# EUROPEAN PATENT APPLICATION

(11) **EP 4 772 942 A1**
(43) Date of publication of application: **08.07.2026**
(21) Application number: 25799920.1
(22) Date of filing: 07.01.2025
(51) Int. Cl.: G03F 7/004

(54) **PHOTOSENSITIVE COMPOSITION, METHOD FOR PREPARING PATTERN, CURED PRODUCT, AND ELECTRONIC COMPONENT**

(30) Priority: 11.11.2024 CN 202411597503
(71) Applicant: Jiangsu Aisen Semiconductor Material Co., Ltd., Suzhou, Jiangsu 215300 (CN); Aisen Semiconductor Materials (Nantong) Co., Ltd., Nantong, Jiangsu 226010 (CN)
(72) Inventor: LIU, Bin, Suzhou, Jiangsu 215300 (CN); ZHANG, Bing, Suzhou, Jiangsu 215300 (CN); XIANG, Wensheng, Suzhou, Jiangsu 215300 (CN); ZHAO, Jianlong, Suzhou, Jiangsu 215300 (CN); HONG, Yongbo, Suzhou, Jiangsu 215300 (CN); MA, Guangyuan, Suzhou, Jiangsu 215300 (CN); HU, Zeming, Suzhou, Jiangsu 215300 (CN); TAN, Xuan, Suzhou, Jiangsu 215300 (CN)
(74) Representative: Monteiro Alves, Inês
(86) International application number: PCT/CN2025/071107
(87) International publication number: WO 2026/097702

(57) **Abstract**

The present invention relates to the technical field of photosensitive dielectric materials, and specifically to a photosensitive composition, a preparation method for a pattern, a cured product, and an electronic component. The photosensitive composition includes a component (a) graft polymer selected from compounds represented by structural formulas as follows: 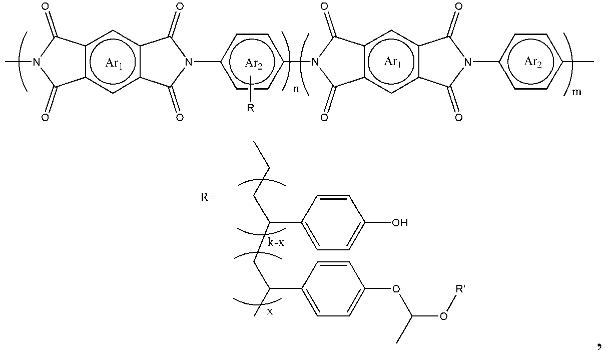 wherein Ar₁ is selected from tetravalent organic groups, Ar₂ is selected from divalent organic groups, and R' is any one selected from the group consisting of alkyl, alkoxy, cycloalkyl, and aryl; m + n = 5 to 200, n / (m + n) = 0.05 to 1, k = 2 to 10, and x = 0.5 to 10; a component (b) photoacid generator; a component (c) thermal crosslinker, which is a CH₂OR"-containing crosslinker, wherein R" is hydrogen or a monovalent organic group; and a component (d) alkaline compound. The photosensitive composition has excellent sensitivity and resolution, is capable of replicating fine patterns, and after low-temperature curing, has low warpage stress, and high chemical stability and adhesion.

## Description

### CROSS-REFERENCE TO RELATED APPLICATION

The present application claims priority to Chinese patent application No. 2024115975031, filed on November 11, 2024 with the Chinese Patent Office, and entitled "PHOTOSENSITIVE COMPOSITION, PREPARATION METHOD FOR PATTERN, CURED PRODUCT, AND ELECTRONIC COMPONENT", the contents of which are incorporated by reference herein in entirety.

### TECHNICAL FIELD

The present invention relates to the technical field of photosensitive dielectric materials, and specifically to a photosensitive composition, a preparation method for a pattern, a cured product, and an electronic component.

### BACKGROUND ART

With gradual increase in semiconductor packaging density, PSPI materials are also progressively advancing towards low-temperature curing, high sensitivity, high resolution, low warpage stress and the like.

According to literature, a method involving reduction of a glass transition temperature of PI polymers combined with use of a thermal base generator (see WO2018225676A1) has been reported. This method can realize low-temperature curing at temperatures of 200-230 °C, resulting in a negative-tone PSPI cured product with excellent adhesion. However, this method cannot meet requirements for high sensitivity, high resolution, and low warpage stress.

Another literature has reported use of a chemically imidized PI polymer containing phenolic hydroxyl or carboxyl groups combined with a suitable crosslinker (see CN102575139A). This method can realize low-temperature curing at a temperature of 200-230 °C, resulting in a positive-tone PSPI cured product with excellent chemical resistance. However, improvement in chemical resistance offered by this method is still limited, and sensitivity of such composition is generally relatively low.

Another literature has reported a method including use of a polymer with phenolic hydroxyl groups, such as poly(p-hydroxystyrene) or phenolic resin, combined with a crosslinker and rubber particles for toughening (see WO2008026406A1), which achieves low-temperature curing at a temperature of 200 °C, resulting in a composition with relatively fast sensitivity, relatively high resolution, and low warpage stress. However, mechanical properties of a cured product obtained through this method are relatively poor, with limited improvement in toughness, potentially leading to issue of reliability abnormality.

In view of this, the present invention is specifically proposed.

### SUMMARY

The present invention aims at providing a photosensitive composition, a preparation method for a pattern, a cured product, and an electronic component. The photosensitive composition provided by embodiments of the present invention has excellent sensitivity and resolution, is capable of replicating fine patterns, and after low-temperature curing, has low warpage stress, and high chemical stability and adhesion.

The present invention is realized as follows.

In the first aspect, the present invention provides a photosensitive composition, including a component (a) graft polymer selected from compounds represented by Formula 1 as follows: 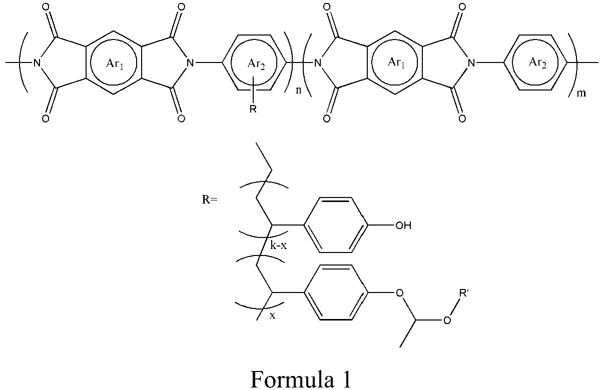
wherein Ar₁ is selected from tetravalent organic groups, Ar₂ is selected from divalent organic groups, and R' is any one selected from the group consisting of alkyl, alkoxy, cycloalkyl, and aryl; m + n = 5 to 200, n / (m + n) = 0.05 to 1, k = 2 to 10, and x = 0.5 to 10;
a component (b) photoacid generator;
a component (c) thermal crosslinker, which is a CH₂OR"-containing crosslinker, wherein R" is hydrogen or a monovalent organic group; and
a component (d) alkaline compound.

In the second aspect, the present invention provides a preparation method for a pattern, including coating the photosensitive composition according to any one of the preceding embodiments on a supporting substrate.

Preferably, the method further includes: performing drying, exposure, development, and heating treatment in sequence after the coating.

Preferably, a light source used in a step of the exposure is i-line.

In the third aspect, the present invention provides a cured product, where the cured product is formed by curing the photosensitive composition according to any one of the preceding embodiments.

Preferably, the cured product includes a surface protective film or an interlayer insulating film.

In the fourth aspect, the present invention provides an electronic component, where the electronic component has the cured product according to the preceding embodiments.

The present invention has beneficial effects as follows: a part of the photosensitive composition provided by the embodiments of the present invention exposed to ultraviolet light is readily soluble in an alkaline aqueous solution, while a part not exposed to the ultraviolet light is insoluble in the alkaline aqueous solution, so that fine patterns can be effectively replicated. Moreover, the photosensitive composition exhibits excellent sensitivity and high resolution, and after low-temperature curing (180-200 °C), it has low warpage stress, high adhesion, and good chemical resistance.

### BRIEF DESCRIPTION OF THE DRAWING

In order to more clearly illustrate technical solutions of embodiments of the present invention, a drawing which needs to be used in the embodiments will be briefly introduced below. It should be understood that the drawing merely shows some embodiments of the present invention, and thus should not be construed as limitation to the scope. Those ordinarily skilled in the art still could obtain other relevant drawings according to the drawing, without using any inventive efforts.
FIGURE is a schematic diagram of a semiconductor package structure provided by embodiments of the present invention.

### DETAILED DESCRIPTION OF EMBODIMENTS

In order to make objectives, technical solutions, and advantages of embodiments of the present invention clearer, the technical solutions in the embodiments of the present invention will be described clearly and completely below. Embodiments, for which no concrete conditions are specified, are carried out according to conventional conditions or conditions recommended by manufactures. If manufacturers of reagents or apparatuses used are not specified, all of them are conventional products commercially available

Embodiments of the present invention provide a photosensitive composition, including following components:
a component (a) graft polymer; a component (b) photoacid generator; a component (c) thermal crosslinker; and a component (d) alkaline compound.

A part of the photosensitive composition provided by embodiments of the present invention exposed to ultraviolet light is readily soluble in an alkaline aqueous solution, while a part not exposed to the ultraviolet light is insoluble in the alkaline aqueous solution, so that fine patterns can be effectively replicated. The photosensitive composition provided by the present invention offers excellent sensitivity and resolution by increasing a dissolution rate ratio (dissolution contrast) of an exposed part and an unexposed part of a pattern relative to an alkaline developer. Moreover, after high-temperature curing, the photosensitive composition has low warpage stress, and excellent chemical resistance and adhesion.

Specifically, for the component (a) graft polymer, from perspectives of processability and heat resistance, a main skeleton thereof is preferably a polyimide-based polymer, and a graft chain skeleton is preferably a poly(p-hydroxystyrene)-based polymer.

Further, the component (a) is more preferably a polyimide-poly(p-hydroxystyrene) graft copolymer, specifically a polymer having a structural unit represented by Formula 1 as follows: 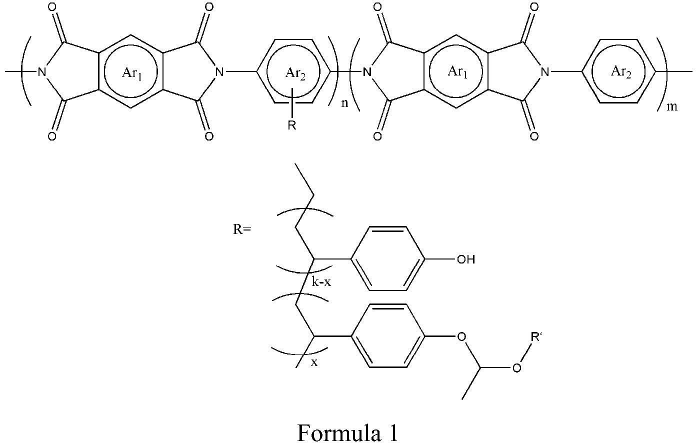 wherein m + n represents the number of repeating structural units in the component (a), and m + n = 5 to 200, for example, any value between 5 and 200, such as 5, 10, 15, 20, 25, 35, 40, 50, 70, 75, 80, 85, 95, 100, 110, 120, 135, 150, 160, 175, 180, 185, 190, 195, and 200. When m + n is less than 5, viscosity of the composition is excessively low, preventing use of the composition as a thick film, while when m + n is greater than 200, the composition becomes overly viscous, thus affecting coating. n / (m + n) = 0.05 to 1, for example, any value between 0.05 and 1, such as 0.05, 0.1, 0.15, 0.2, 0.25, 0.3, 0.35, 0.4, 0.5, 0.6, 0.7, 0.8, 0.9, and 1.

Solubility of the composition in an aqueous alkaline solution originates from phenolic hydroxyl groups and thus preferably containing a proportion of the structure above. More preferably, k = 2 to 10, for example, any value between 2 and 10, such as 2, 4, 6, 8, and 10. Excessively large k units will lead to deterioration in film toughness. More preferably, x = 0.5 to 10, for example, any value between 0.5 and 10, such as 0.5, 1, 3, 5, 7, 9, and 10. Excessively small x units will result in significant loss of developed film thickness. Therefore, by adjusting a grafting amount of p-hydroxystyrene and an acetalization amount of the phenolic hydroxyl groups, a photosensitive graft composition with a moderate dissolution rate can be obtained.

Further, Ar₁ is a tetravalent organic group, for example, Ar₁ is, at each occurrence, identically or differently any one selected from tetravalent organic groups represented by Formula 2 as follows: 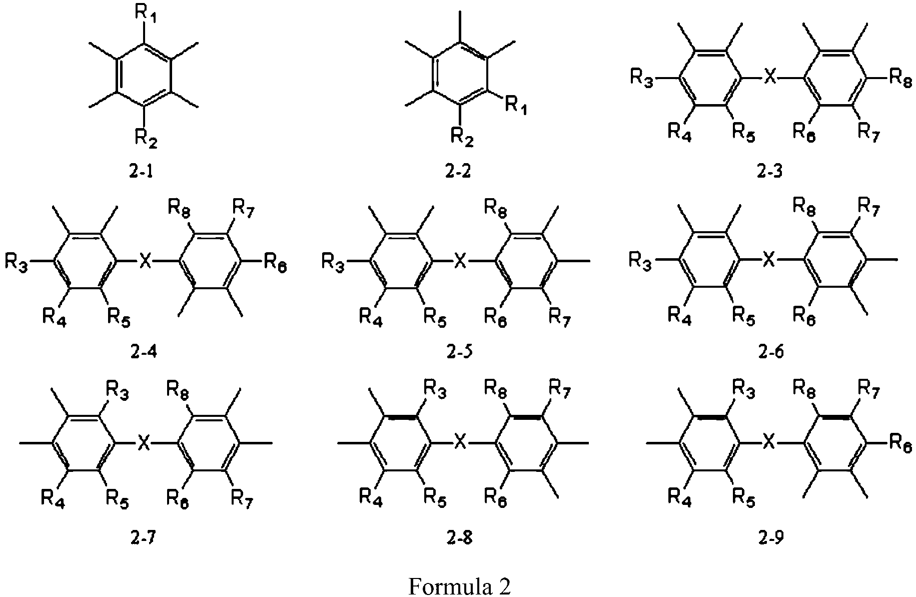 wherein R₁ to R₈ are each a monovalent organic group, and X is a divalent group.

Specifically, R₁ to R₈ are each independently any one selected from the group consisting of hydrogen, halogen, and C₁*-*C₅ substituted or unsubstituted alkyl. Preferably, R₁ to R₈ are each independently any one selected from the group consisting of hydrogen, fluorine atom, bromine atom, iodine atom, methyl, ethyl, n-propyl, t-butyl, isobutyl, and trifluoromethyl.

X is any one selected from the group consisting of oxygen atom, C₁-C₅ substituted or unsubstituted alkylene, sulfur atom, sulfone, and carbonyl, and X is any one selected from the group consisting of oxygen atom, methylene, ethylene, sulfur atom, sulfone, carbonyl, C(CH₃)₂, and C(CF₃)₂.

Specifically, in Formula 1, Ar₁ is a tetravalent organic group, typically a residue derived from tetracarboxylic dianhydride or a derivative thereof having an amide ester structure formed by the tetracarboxylic dianhydride or the derivative thereof and a diamine, preferably a tetravalent aromatic group, preferably a residue of tetracarboxylic dianhydride or a derivative thereof having a structure where four bonding sites are all present on an aromatic ring. Examples of such tetracarboxylic dianhydride may include aromatic tetracarboxylic dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl)ether dianhydride, 1,2,5,6-naphthalenetetracarboxylic dianhydride, 9,9-bis(3,4-dicarboxyphenyl)fluorene dianhydride, 9,9-bis{4-(3,4-dicarboxyphenoxy)phenyl} fluorene dianhydride, 2,3,6,7-naphthalenetetracarboxylic dianhydride, 2,3,5,6-pyridine tetracarboxylic dianhydride, 3,4,9,10-perylene tetracarboxylic dianhydride, and 2,2-bis(3,4-dicarboxyphenyl)hexafluoropropane dianhydride, and aliphatic tetracarboxylic dianhydrides such as butane tetracarboxylic dianhydride and 1,2,3,4-cyclopentane tetracarboxylic dianhydride. These may be used individually or in combination of two or more.

Further, Ar₂ is selected from divalent organic groups, for example, Ar₂ is, at each occurrence, identically or differently any one selected from divalent organic groups represented by Formula 3: 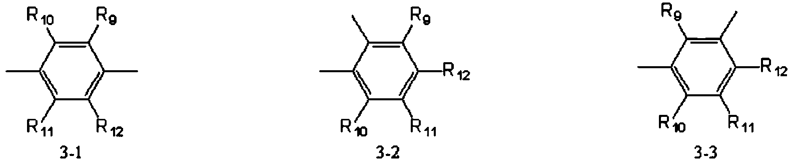 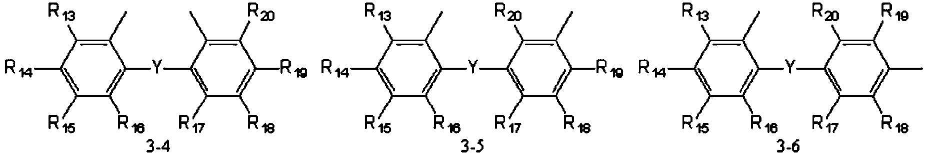 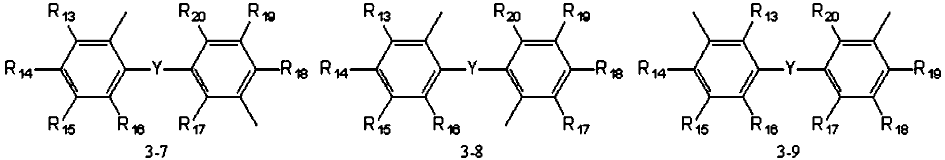 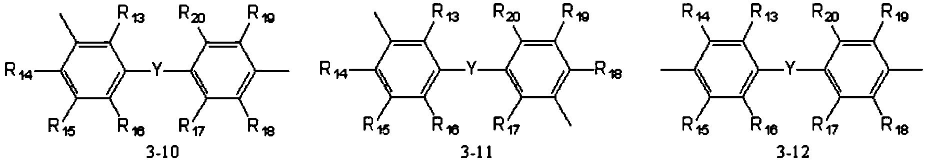 wherein R₉ to R₂₀ are each a monovalent organic group, and Y is a divalent group.

Specifically, R₉ to R₂₀ are each independently any one selected from the group consisting of hydrogen, halogen, and C₁-C₅ substituted or unsubstituted alkyl; and preferably, R₉ to R₂₀ are each independently any one selected from the group consisting of hydrogen, fluorine atom, bromine atom, iodine atom, methyl, ethyl, n-propyl, t-butyl, isobutyl, and trifluoromethyl.

Y is any one selected from the group consisting of oxygen atom, C₁-C₅ substituted or unsubstituted alkylene, sulfur atom, sulfone, and carbonyl, and Y is any one selected from the group consisting of oxygen atom, methylene, ethylene, sulfur atom, sulfone, carbonyl, C(CH₃)₂, and C(CF₃)₂.

Further, in Formula 1, Ar₂ is a divalent organic group, typically a residue derived from an amino acid having an amide structure formed from an amino acid and a diamine, preferably a divalent aromatic group, preferably an amino acid residue having a structure in which two binding sites are present on an aromatic ring. Examples of such amino acid may include p-aminobenzoic acid, m-aminobenzoic acid, o-aminobenzoic acid, etc. These may be used individually or in combination of two or more.

In addition, in order to improve adhesion to a substrate, Ar₂ moiety can be obtained by copolymerizing a certain proportion of aliphatic groups having a siloxane structure, preferably 1-10 mol% of bis(3-aminopropyl)tetramethyldisiloxane, bis(p-aminophenyl)octamethylpentasiloxane, or the like, as long as heat resistance is not destroyed.

A terminal group of the aromatic polyamide represented by Formula 1 becomes carboxylic acid or amine according to a charging ratio of Ar₁ to Ar₂. Depending on requirements, one or two end-capping agents may react with polymer terminals so that one or two terminals are each a saturated aliphatic group, an unsaturated aliphatic group, a carboxyl group, a phenolic hydroxyl group, a sulfonic acid group, a mercapto group, or the like. In this case, an end-capping rate is preferably 30%-100%.

It should be noted that: (1) the halogen mentioned in the above R₁ to R₂₀ is not limited to F, and may also be bromine, chlorine, etc.

(2) The C₁-C₅ substituted or unsubstituted alkyl mentioned in the above R₁ to R₂₀ may be a C₁-C₃ substituted or unsubstituted alkyl, for example, an unsubstituted alkyl, such as methyl, ethyl, propyl, n-butyl, isopropyl, isobutyl, and tert-butyl, or a substituted alkyl, such as trifluoromethyl, trifluoroethyl, difluoromethyl, and trichloromethyl.

(3) The C₁-C₅ substituted or unsubstituted alkylene mentioned in the above R₁ to R₂₀ may be a C₁-C₃ unsubstituted alkylene, for example, an unsubstituted alkylene such as methylene, ethylene, and propylene, or a C₁-C₃ substituted alkylene, such as halogen (fluorine, bromine, and chlorine) substituted methylene, and halogen substituted ethylene.

R' is any one selected from the group consisting of alkyl, alkoxy, cycloalkyl, and aryl, for example, including, but not limited to, ethyl, propyl, butyl, cyclohexane, phenyl and the like.

Based on a weight average molecular weight, a molecular weight of the component (a) is preferably 3,000-200,000, and more preferably 5,000 to 100,000. The molecular weight herein is measured by gel permeation chromatography and converted by a standard polystyrene standard curve.

In embodiments of the present invention, the graft polymer having the structural unit as represented by Formula 1 is obtained as follows: dianhydride and diamine are typically subjected to polycondensation to obtain a polyamic acid polymer, which is then subjected to chemical imidization to yield a polyimide polymer, then chloromethylation and xanthation are carried out to obtain a macroinitiator, followed by graft polymerization to yield a polyimide-g-poly(p-hydroxystyrene) graft copolymer, and finally, the graft copolymer is acetalized with a vinyl ether-based compound to obtain the graft copolymer in the present invention.

Specifically, in a first step, the polyamic acid can be prepared through reaction between diamine and dianhydride, and then the polyimide is prepared through chemical imidization. In a second step, chloromethylation and xanthation are carried out on the polyimide to obtain the macroinitiator. In a third step, the macroinitiator prepared in the second step is grafted to p-hydroxystyrene by RAFT polymerization to prepare the graft polymer. In a fourth step, the graft copolymer is acetalized with the vinyl ether-based compound to obtain the graft copolymer of the present invention. Conditions and operations of the above steps are well known to those skilled in the art, and will not be described in detail in embodiments of the present invention.

The component (b) photoacid generator is a compound that generates an acid upon exposure to active light or radiation, for example, any one or combination of two or more selected from the group consisting of diaryliodonium salts, triarylsulfonium salts, imide sulfonate derivatives, and oxime sulfonate compounds. From perspectives of thermal stability and photosensitivity, the component (b) is preferably a triarylsulfonium salt, more preferably used in combination with a sensitizer.

For sulfonate anions contained in the triarylsulfonium salt contained in the photosensitive composition in embodiments of the present invention, examples may include alkanesulfonate anions, arylsulfonate anions substituted with a fluorine atom or an organic group having a fluorine atom, etc.

Specifically, the triarylsulfonium salt is any one or combination of two or more selected from following specific examples, but the triarylsulfonium salts provided in the embodiments of the present invention are not limited to following specific examples or combinations thereof.

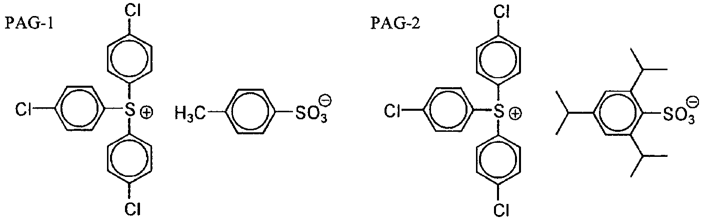

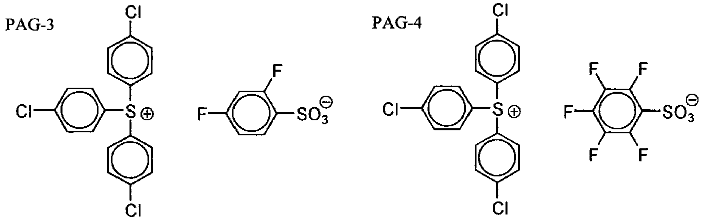

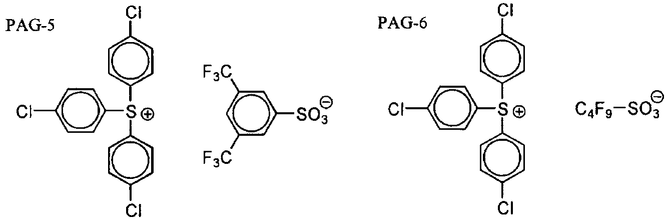

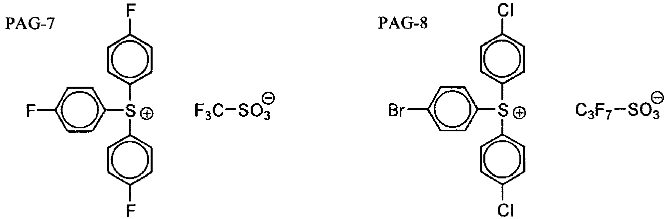

Further, examples of the diaryliodonium salts include diphenyliodonium trifluoroacetate, diphenyliodonium trifluoromethanesulfonate, 4-methoxyphenyliodonium trifluoromethanesulfonate, 4-methoxyphenyliodonium trifluoroacetate, phenyl, 4-(2'-hydroxy-1'-tetradecyloxy)phenyliodonium trifluoromethanesulfonate, etc.

Imidosulfonate derivatives include, but are not limited to, trifluoromethanesulfonyloxybicyclo[2.2.1]hept-5-terminal dicarboximide, succinimide trifluoromethanesulfonate, phthalimide p-toluenesulfonate, phthalimide trifluoromethanesulfonate, N-hydroxynaphthalimide methanesulfonate, and examples thereof include N-hydroxy-5-norbornene-2,3-dicarboximide propanesulfonate.

Among compounds that produce an acid upon exposure to active light or radioactive rays, from perspectives of sensitivity, resolution, dielectric constant, dimensional stability, etc., an oxime compound is preferred, and an oxime sulfonate compound is more preferred. As the oxime sulfonate compound, i.e., a compound having an oxime sulfonate residue, a compound having an oxime sulfonate residue represented by following formulas is preferably exemplified.

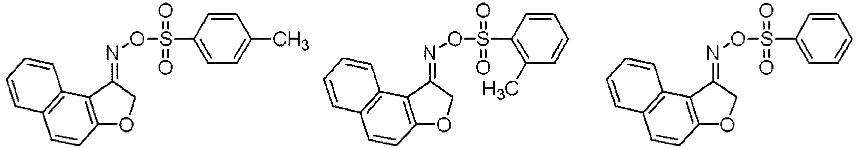

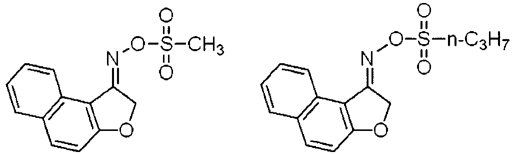

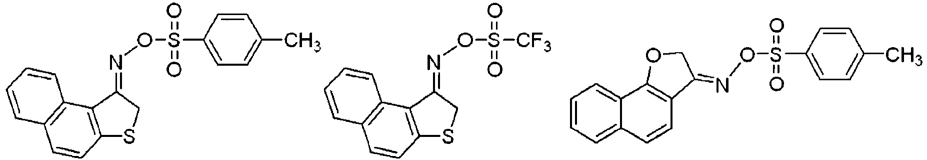

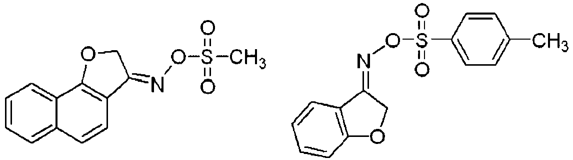

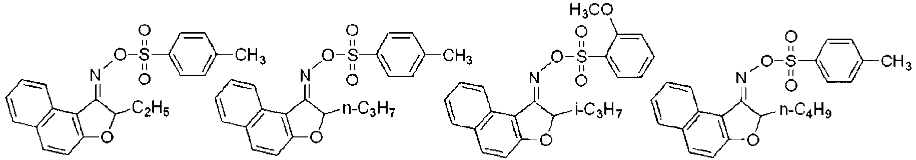

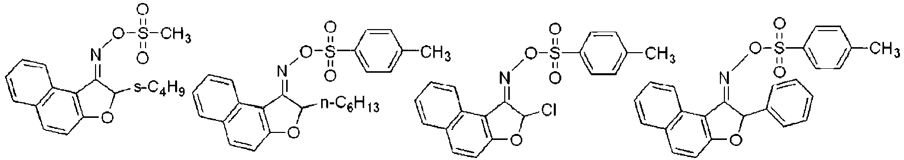

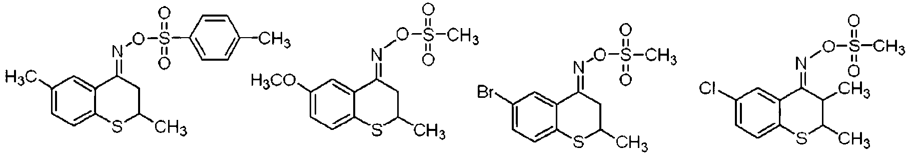

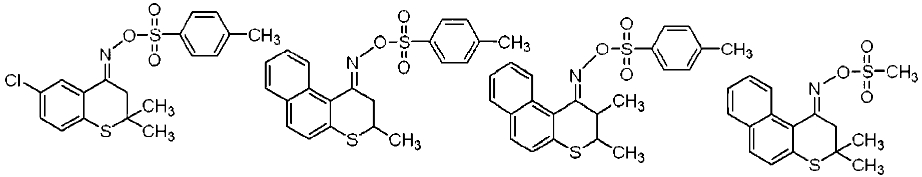

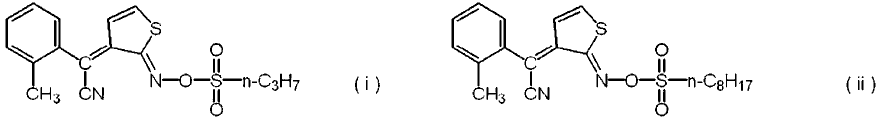

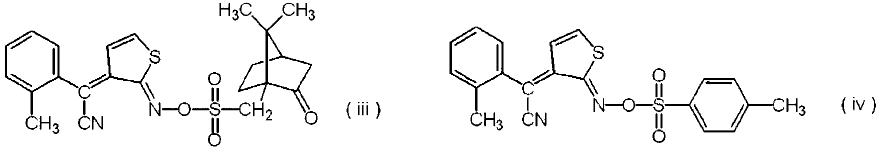

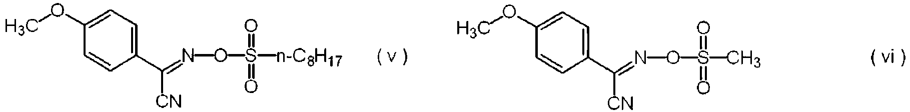

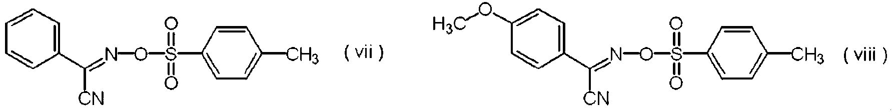

In the photosensitive resin composition provided by embodiments of the present invention, based on 100 parts by weight of a content of the component (a), a content of the component (b) is 1-5 parts by weight, for example, any value between 1 and 5 parts by weight, such as 1 part by weight, 2 parts by weight, 3 parts by weight, 4 parts by weight, and 5 parts by weight.

The photoacid generator provided by embodiments of the present invention may be used individually or in combination of two or more. When two or more are used in combination, compounds that generate two or more organic acids having distinct total atomic numbers, excluding hydrogen atoms, are preferably combined.

The photosensitive composition provided by embodiments of the present invention, based on a purpose of easily obtaining a cured film, further includes (c) thermal crosslinker, which is a crosslinker having a -CH₂OR" (R" is a hydrogen atom or a monovalent organic group) group. In a step that the photosensitive polymer composition of the present invention is subjected to a heating treatment after coating, exposure, and development, it is crosslinked with a polymer as the component (a), or a self-polymerized compound in the step of heating treatment. In addition, the crosslinker, having affinity for alkaline aqueous solutions, can increase a dissolution rate in the alkaline aqueous solutions.

In embodiments of the present invention, the component (c) is a crosslinker structurally having a -CH₂OR" (R" is a hydrogen atom or a monovalent organic group) group. The compound may contain at least one such group, but preferably two or more. The component (c) herein is selected from compounds represented by Formulas 4-2-1 and 4-2-2 as follows.

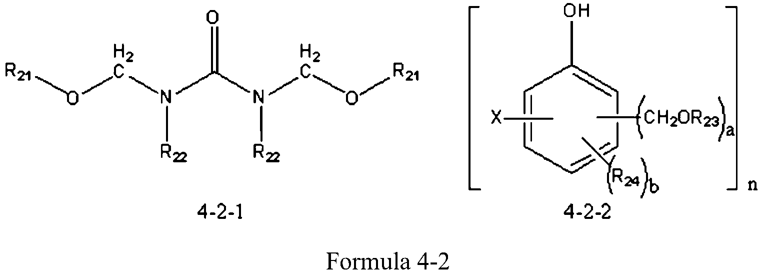

In Formula 4-2-1, R₂₁ is independently a hydrogen atom or a monovalent organic group, and R₂₂ is independently a hydrogen atom or a monovalent organic group, and R₂₁ and R₂₂ may also be combined with each other to form a ring structure that may have a substituent.

Following Formula 4-2-1-1 represents specific examples of the compound represented by Formula 4-2-1, and this component can use these compounds individually or in combination of two or more.

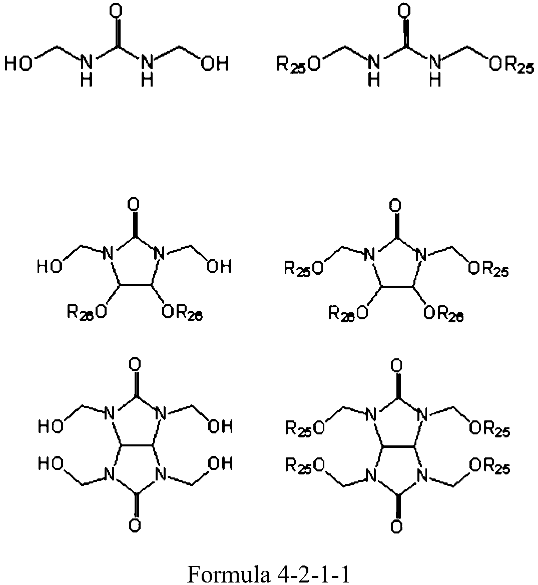

Herein, R₂₅ is an alkyl group having 1 to 20 carbon atoms, preferably an alkyl group having 1 to 6 carbon atoms, and R₂₆ is an alkyl group having 1 to 10 carbon atoms.

Following 4-2-2-1 represents specific examples of the compound represented by Formula 4-2-2, and this component can use these compounds individually or in combination of two or more.

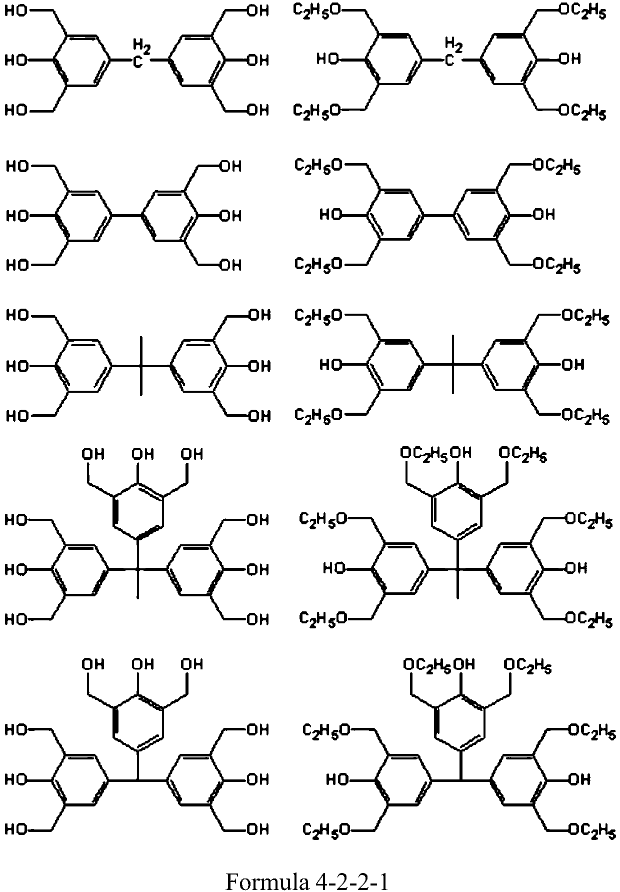

In Formula 4-2-2, R₂₃ is a hydrogen atom or a monovalent organic group, and R₂₃ is preferably hydrogen, alkyl or alkenyl. The number of carbon atoms of alkyl or alkenyl is preferably 1-20. R₂₄ is selected from monovalent organic groups, R₂₄ is preferably alkyl, alkenyl, alkoxyalkyl or hydroxymethyl, and the number of carbon atoms is preferably 1-20. n is an integer from 1 to 4, X is a single bond or a monovalent to tetravalent organic group. Examples may include alkyl having 1-10 carbon atoms, alkylene (for example, ethylene) having 2-10 carbon atoms, arylene (for example, phenylene) having 6-30 carbon atoms, or a group obtained by substituting part or all of hydrogen atoms of these hydroxyl groups with halogen atoms such as fluorine atoms. These groups may further contain phenyl, sulfone, carbonyl, ether bond, thioether bond, amide bond, and the like. a is an integer from 1 to 4, and b is an integer from 0 to 3. R₂₃ is identical or different when a is 2, 3 or 4, and R₂₄ is identical or different when b is 2 or 3.

Purity of the compounds represented by Formula 4-2 is preferably 75% or higher, and more preferably 85% or higher. When the purity is 85% or higher, the compounds have excellent storage stability, and can sufficiently undergo a crosslinking reaction of a polyimide composition. In addition, since unreacted groups which become water-absorbing groups can be reduced, water absorption of the polyimide composition can be reduced. Examples of a method for obtaining a high-purity thermal crosslinker include recrystallization, distillation, etc. The purity of the thermal crosslinker can be obtained by liquid chromatography.

Relative to 100 parts by mass of the component (a) polyimide, a content of the component (c) thermal crosslinker is preferably 5 parts by mass or more, and more preferably 10 parts by mass or more. If 5 parts by weight or more, the cured film has an increased crosslinking density, high chemical resistance, and low curing warpage. Furthermore, if 10 parts by mass or more, the chemical resistance is higher, the low curing warpage is better, and higher mechanical properties can be obtained. In addition, in terms of storage stability and mechanical strength of the composition, 30 parts by mass or less is preferred.

Further, the content of c is 5-30 parts, for example, any value between 5 and 30 parts, such as 5 parts, 7 parts, 8 parts, 10 parts, 15 parts, 20 parts, 25 parts, and 30 parts.

The photosensitive composition of embodiments of the present invention further includes the component (d) alkaline compound, so as to reduce changes of properties from exposure to heating over time. As the alkaline compound, a compound having a structure represented by following Formula 5 can be preferably given. 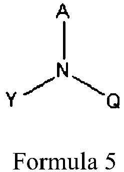 wherein A, Y, and Q each may be independently selected from the group consisting of alkyl, alkoxy, and cyclic alkyl, for example, including, but not limited to, ethyl, ethoxy, ethylethoxy, cyclohexanyl, etc. Following Formula 5-1 represents specific examples of the compound represented by Formula 5, and this can use these compounds individually or in combination of two or more.

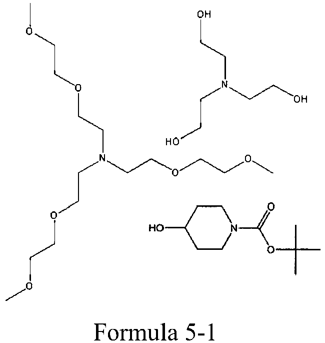

In the photosensitive composition provided by embodiments of the present invention, based on 100 parts by weight of the content of the component (a), a content of the component (d) is 0.001-2 parts by weight, for example, any value between 0.001 and 2 parts by weight, such as 0.001 parts by weight, 0.01 parts by weight, 0.1 parts by weight, 0.5 parts by weight, 1 part by weight, 1.5 parts by weight, and 2 parts by weight.

In embodiments of the present invention, a ratio of the photoacid generator to the alkaline compound is preferably acid generator / alkaline compound (molar ratio) = 2.5 to 300. That is, from perspectives of sensitivity and resolution, the molar ratio is preferably 2.5 or higher, and preferably 300 or lower from perspectives of suppressing reduction in resolution caused by thickening of a relief pattern over time due to exposure to heat treatment. The acid generator / alkaline compound (molar ratio) is more preferably 5.0-200, and further preferably 7.0-150.

The photosensitive composition provided by embodiments of the present invention further contains (e) silane coupling agent, typically an organosilane compound. Examples of the organosilane compound may include γ-aminopropyltrimethoxysilane, γ-aminopropyltriethoxysilane, vinyltriethoxysilane, vinyltrimethoxysilane, γ-glycidoxypropyltriethoxysilane, γ-glycidoxypropyltrimethoxysilane, γ-methacryloxypropyltrimethoxysilane, γ-acryloxypropyltrimethoxysilane, γ-ureidopropyltriethoxysilane, 3-mercaptopropyltrimethoxysilane, 3-isocyanatopropyltriethoxysilane, bis(2-hydroxyethyl)-3-aminopropyltriethoxysilane, triethoxysilylpropylethylcarbamate, 3-(triethoxysilyl)propylsuccinic anhydride, phenyltriethoxysilane, phenyltrimethoxysilane, N-phenyl-3-aminopropyltrimethoxysilane, 3-triethoxysilyl-N-(1,3-dimethylbutylidene) propylamine, 2-(3,4-epoxycyclohexyl)ethyltrimethoxysilane, etc.

When the organosilane compound is contained, adhesion of the photosensitive polyimide composition after curing to the substrate can be improved. In cases of containing the organosilane compound, relative to 100 parts by mass of the component (a), a content of the organosilane compound is more preferably 0.5-15 parts by mass, and further preferably 0.5-10 parts by mass, for example, any value between 0.5 and 15 parts, such as 0.5 parts, 1 part, 2 parts, 3 parts, 4 parts, 5 parts, 6 parts, 7 parts, 8 parts, 9 parts, 10 parts, 11 parts, 12 parts, 13 parts, 14 parts, and 15 parts.

The polyimide composition of the present invention further contains (f) solvent, preferably an organic solvent. For example, ketones, esters, lactones, ethers, halogenated hydrocarbons, hydrocarbons and the like can be used. Specific examples may include polar solvents such as γ-butyrolactone, N-methyl-2-pyrrolidone, N-acetyl-2-pyrrolidone, N,N-dimethylacetamide, N,N-dimethyl sulfoxide, hexamethylphosphoramide, dimethyl imidazolidinone, tetraethyl urea, tetramethylurea, ethyl lactate, 3-methoxy-N,N-dimethylpropanamide, and N-acetyl-ε-caprolactam. Acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene, 1-methoxy-2-propanol, 1-methoxy-2-acetoxypropane, propylene glycol 1-monomethyl ether 2-acetate, etc. can also be used. The component (f) can be used individually or in combination of two or more.

When the component (f) is contained, relative to 100 parts by mass of the component (a), an amount of the component (e) compounded is preferably 50 to 1,000 parts by mass, more preferably 100 to 200 parts by mass, for example, any value between 50 and 1,000 parts, such as 50 parts, 60 parts, 70 parts, 100 parts, 150 parts, 200 parts, 300 parts, 400 parts, 500 parts, 600 parts, 700 parts, 800 parts, 900 parts, and 1,000 parts.

The present invention may further contain (g) leveling agent. The leveling agent may be a surfactant, so as to improve a coating property with a substrate. Examples of the surfactant may include fluorine-based surfactants, such as Fluorad (tradename, manufactured by Sumitomo 3M Ltd.), Megafac (tradename, manufactured by DIC Corp.), and Surflon (tradename, manufactured by Asahi Glass Co. , Ltd.); organosiloxane surfactants, such as KP341 (tradename, manufactured by Shin-Etsu Chemical Co., Ltd.), DBE (tradename, manufactured by Chisso Corporation), Polyflow, Glanol (tradename, manufactured by Kyoeisha Chemical Co., Ltd.), and BYK (tradename, manufactured by BYK-Chemie GmbH); and acrylic polymer surfactants, such as Polyflow (tradename, manufactured by Kyoeisha Chemical Co., Ltd.), etc.

When the component (f) is contained, relative to 100 parts by mass of the component (a), a content of the component (g) is 100-1,000 ppm, for example, any value between 100 ppm and 1,000 ppm, such as 100 ppm, 200 ppm, 300 ppm, 400 ppm, 500 ppm, 600 ppm, 700 ppm, 800 ppm, 900 ppm, and 1,000 ppm.

Further, a preparation method for the photosensitive composition provided by embodiments of the present invention is described. For example, the photosensitive composition can be obtained by uniformly mixing the components (a) to (d) and the components (e) to (g) to be used as required. As dissolution methods, stirring and heating can be mentioned. During heating, a heating temperature is set preferably in a range that does not destroy performance of the polyimide composition, typically from room temperature to 80 °C. Besides, a dissolution order of various components is not particularly limited, for example, including a method of sequentially dissolving starting from a compound with low solubility. In addition, for components that are prone to generating bubbles during stirring and dissolution, such as surfactants and some adhesion promoters, they can be added after all other components have been dissolved, so as to prevent poor dissolution of the other components due to the generation of bubbles.

A resulting photosensitive polyimide composition is preferably filtered using a filter to remove impurities and particles. A pore size of the filter is 0.5-0.02 µm, such as 0.5 µm, 0.2 µm, 0.1 µm, 0.05 µm, and 0.02 µm, but not limited thereto. Materials of the filter include polypropylene (PP), polyethylene (PE), nylon (NY), polytetrafluoroethylene (PTFE), etc., and polyethylene and nylon are preferred. When the photosensitive polyimide composition contains inorganic particles, it is preferable to use a filter having a pore size larger than a particle size of the inorganic particles.

Further, a cured product provided by embodiments of the present invention can be obtained by curing the above photosensitive composition. The cured product of the present invention can be used as a patterned cured film or as a non-patterned cured film.

A method for manufacturing the patterned cured film or a preparation method for a pattern, for example, includes: a step of coating the above photosensitive composition on a substrate and drying the coated photosensitive composition to form a photosensitive polyimide film (a film-forming step); a step of exposing the photosensitive polyimide film (an exposure step); a step of acid-diffusing the photosensitive composition (a post-exposure baking step); a step of developing the exposed photosensitive polyimide film with an alkaline aqueous solution to form a patterned polyimide film (a developing step); and a step of heating the patterned polyimide film (a heating step). A method for manufacturing the non-patterned cured film, for example, includes the film-forming step and the heating step in the above, and may further include the exposure step.

In the film-forming step, the above photosensitive composition is coated, for example, on a supporting substrate, such as a metal (e.g., Cu) substrate, a glass substrate, a semiconductor, a metal oxide insulator (such as TiO₂ and SiO₂), or a silicon nitride by a dipping method, a spray method, a screen printing method, or a spin coating method. From an operational perspective, the coated positive-tone photosensitive polyimide composition also can be dried with a hotplate, an oven, or the like (e.g., at 90-150 °C for 1-5 minutes) before use. Prior to coating, the supporting substrate also can be cleaned with acetic acid or the like. The resulting photosensitive polyimide film has a thickness preferably ranging from 5 to 20 µm.

In the exposure step, for example, the photosensitive polyimide film formed on the substrate is irradiated with the active light through a mask. From a perspective of transparency of the component (a), irradiation with i-line can be suitably used.

In the development step, for example, an exposed portion of the photosensitive polyimide film after the exposure step is removed with a developer to pattern the photosensitive polyimide film. For the developer, in cases of an alkali-soluble photosensitive composition, an alkaline aqueous solution such as sodium hydroxide, potassium hydroxide, sodium silicate, ammonia, ethylamine, diethylamine, triethylamine, triethanolamine, and tetramethylammonium hydroxide (TMAH) can be suitably used. An alkali concentration of these aqueous solutions is preferably set to be 0.1-10 mass%. Further, alcohols or surfactants also can be added to the above developer for use. They can be respectively added by an amount of preferably 0.01-10 parts by mass, more preferably 0.1-5 parts by mass, relative to 100 parts by mass of the developer. The patterned photosensitive polyimide film is referred to as a patterned polyimide film.

In the heating step, the photosensitive composition can be cured by heating the patterned polyimide film or the photosensitive polyimide film. Particularly, a film obtained by curing the patterned polyimide film is referred to as a patterned cured film. A heating temperature is preferably 150-250 °C, preferably 230 °C or less, more preferably 170 °C or more, and still more preferably 180-200 °C. A heating period is preferably 20 minutes to 6 hours, and more preferably 30 minutes to 3 hours. Multi-stage heating may also be performed. The heating treatment may be performed, for example, using an oven such as a quartz tube furnace, a hotplate, a rapid thermal anneal, a vertical diffusion furnace, an infrared curing oven, an electron beam curing oven, and a microwave curing oven. Furthermore, the heating step also may be conducted either in air or in an inert atmosphere such as nitrogen. However, performing the heating step in the nitrogen atmosphere can prevent oxidation of patterns, and thus an inert atmosphere such as nitrogen is preferable.

The cured product of the present invention can be used as an interlayer insulating film, a surface protective film, or the like.

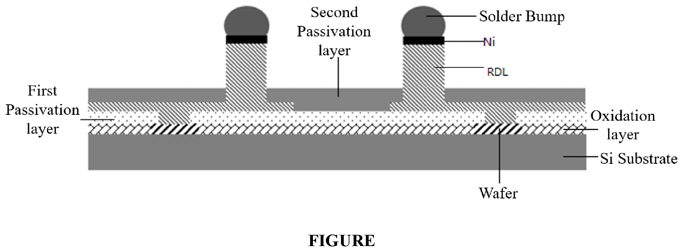

The interlayer insulating film and the surface protective film of the present invention can be used for electronic components and the like, and the electronic component of the present invention can be used for semiconductor devices and the like. The semiconductor devices can be used in various electronic devices and the like, with a schematic diagram of a semiconductor package structure of the present invention as shown in FIG. 1.

As a result, excellent antirust effect and adhesion effect are exhibited to the supporting substrate (particularly, the copper substrate and the copper alloy substrate), and coloring of the cured film and the supporting substrate (particularly, the copper substrate and the copper alloy substrate) can be suppressed.

Examples of the above semiconductor devices may include semiconductor packages such as a wafer level chip scale package (WLCSP) and a fan-out wafer level package (FOWLP). In addition, the interlayer insulating film and the surface protective film of the present invention can also be applied to circuit-forming substrates, where the circuit-forming substrates can be used in hard disk drive suspensions and flexible wiring boards, among others.

Abbreviations of the compounds provided by embodiments of the present invention are corresponding to following substances:
ODA: 4,4-diaminodiphenyl ether; SiDA: 1,3-bis(3-aminopropyl)tetramethyldisiloxane; ODPA: 4,4'-oxydiphthalic anhydride; Py: pyridine; Et₂A: acetic anhydride; PhA: phthalic anhydride; NMP: N-methyl-2-pyrrolidone; TMAH: tetramethylammonium hydroxide; CMM: chloromethyl methyl ether; SnCl₄: tin tetrachloride; AIBN: azobisisobutyronitrile; 4-HS: p-hydroxystyrene; EVE: vinyl ethyl ether; PTST: pyridinium p-toluenesulfonate; St: styrene; and 6FAP: 3,3-diamino-4,4-dihydroxydiphenyl-hexafluoropropane.

The component (a) synthesized in the following synthesis examples of the present invention is tested for molecular weight, grafting amount, and grafting ratio, with specific test methods as follows.

### (1) Measurement of Molecular Weight

A number average molecular weight is determined by standard polystyrene conversion using a gel permeation chromatography (GPC) method under following conditions. Relative to 0.5 mg of A, 1 mL of solution with solvent [tetrahydrofuran (THF) / dimethylformamide (DMF) = 1 / 1 (volume ratio)] is used for measurement.

Measurement device: detector L4000 UV manufactured by Hitachi, Ltd.; and pump: L6000 manufactured by Hitachi, Ltd.

C-R4A Chromatopac manufactured by Shimadzu Corporation.

Measurement conditions: chromatographic column Gelpack GL-S300 MDT-5 ×2; eluent: THF / DMF = 1 / 1 (volume ratio), LiBr (0.03 mol/L), H₃PO₄ (0.06 mol/L); flow rate: 1.0 mL/min; and detector: UV 270 nm.

### (2) Measurement of Grafting Ratio n / (m + n)

Measurement equipment: AV400M manufactured by Bruker BioSpin, Inc.

Magnetic field strength: 400 MHz; reference substance: tetramethylsilane (TMS); and solvent: dimethyl sulfoxide (DMSO).

### (3) Measurement of Grafting Amount k

Measurement equipment: AV400M manufactured by Bruker BioSpin, Inc.

Magnetic field strength: 400 MHz; reference substance: tetramethylsilane (TMS); and solvent: dimethyl sulfoxide (DMSO).

Features and performance of the present invention are further described in detail below in conjunction with examples.

### Synthesis Example 1

An example of the present invention provides a preparation method for a graft polymer A1 as follows.

Under a dry nitrogen flow, 20.02 g (0.1 mol) of ODA was dissolved in 200 g of NMP, and a resulting solution was then cooled to -10 °C. Subsequently, 26.37 g (0.085 mol) of ODPA was slowly added, so that a temperature of reaction solution did not exceed 0 °C. Stirring was continued for 3 hours, and then 4.44 g (0.03 mol) of PhA was added. Stirring was continued at room temperature for 2 hours to yield a polyamic acid solution.

39.55 g of Py and 30.6 g of Et2A were added into the polyamic acid solution, and mixture was heated to 120 °C, and then further reacted for 12 h. Upon completion of reaction, solution was poured into 2 L of deionized water for precipitation. Precipitate was washed with water and vacuum-dried at 80 °C to yield a polyimide resin, with a structural formula as shown below:

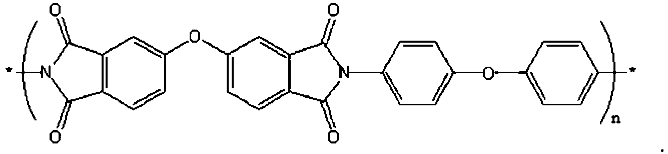

5 g of dried polyimide resin was dissolved in 30 mL of dichloroethane, 80 µL of SnCl₄ was added, and mixture was heated to 70 °C. 3 mL of CMM was slowly added dropwise to system, followed by stirring for 5 h. Upon completion of reaction, solution was poured into 300 mL of methanol for precipitation. Precipitate was washed, and dried at 80 °C for 12 h, to yield a chloromethylated polyimide resin, with a structural formula as shown below:

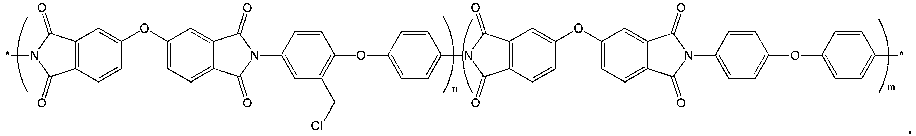

1 g of dried chloromethylated polyimide resin was dissolved in 20 mL of NMP, and upon completion of dissolution, 0.1 g of potassium ethylxanthate was added, followed by reaction at room temperature for 24 h. Upon completion of reaction, the solution was poured into 200 mL of deionized water for precipitation. Precipitate was dried at 80 °C for 12 h, to yield a macroinitiator, with a structural formula as shown below:

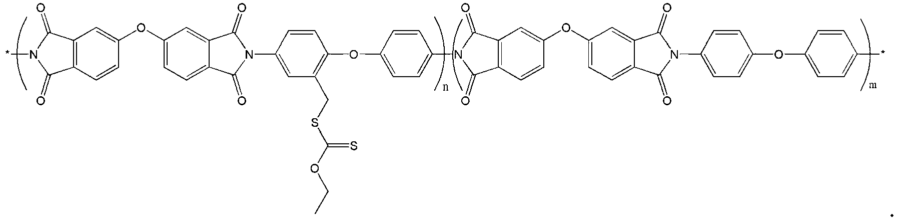

1 g of dried macroinitiator was dissolved in 20 ml of NMP. Upon completion of dissolution, temperature was raised to 65 °C. 3 g of 4-HS was added dropwise, and then 0.01 g of AIBN was added, followed by RAFT polymerization for 2 h. Upon completion of reaction, solution was cooled to room temperature, and poured into 200 mL deionized water for precipitation. Precipitate was washed multiple times with ethanol, and dried at 80 °C for 12 h, to yield a polyimide-g-poly(p-hydroxystyrene) graft copolymer A1, with a structural formula as shown below, where a molecular weight was 39,000, n / (m + n) = 40%, and k = 3.5.

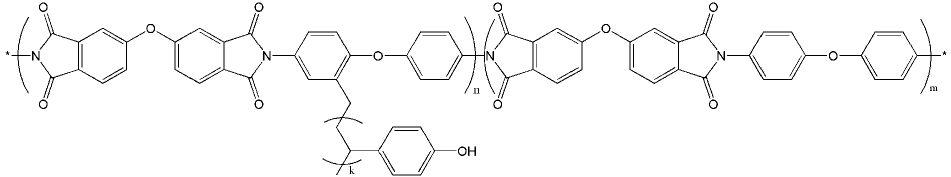

### Synthesis Example 2

An example of the present invention provides a preparation method for a graft polymer A2 as follows.

1 g of dried polyimide-g-poly(p-hydroxystyrene) was dissolved in 20 mL of NMP. Upon completion of dissolution, temperature was raised to 35 °C. 2 g of EVE and 0.1 g of PTST were added, and reaction was continued for 5 h. Upon completion of reaction, solution was cooled to room temperature, and poured into 200 mL deionized water for precipitation. Precipitate was washed multiple times with ethanol, and dried at 80 °C for 12 h to yield the graft copolymer A2, with a structural formula as shown below, where a molecular weight was 39,050, n / (m + n) = 40%, k = 3.5, and x = 2.5.

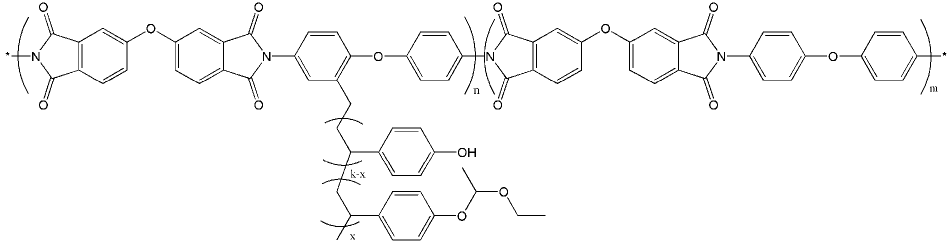

### Synthesis Example 3

An example of the present invention provides a preparation method for a graft polymer A3 as follows.

192 g of methanol, 172.32 g of 4-HS, 19.53 g of St, and 15 g of AIBN were successively added to a four-necked flask, and stirred and dissolved to be clear. Reaction vessel was evacuated and purged with nitrogen to remove air, then heated to 75 °C, and reacted for 18 h, and then reaction was terminated. A prepared solution of sodium methoxide (0.4 g) was slowly added to system, followed by reaction for 6 h. Extraction was carried out 2-3 times with n-heptane at a 1:1 mass ratio to reaction solution, to remove unreacted monomers and initiators in the reaction solution. Methanol in the reaction solution was replaced with PGMEA to yield a PGMEA solution of a desired concentration. PHS resin A3 was obtained, with a structural formula as shown below, where a ratio of p-hydroxystyrene to styrene repeating units was 80 / 20, i.e., m was 20, and n was 80.

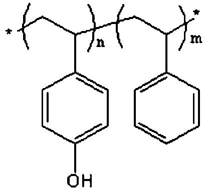

### Synthesis Example 4

An example of the present invention provides a preparation method for a graft polymer A4 as follows.

Under a dry nitrogen flow, 36.63 g (0.1 mol) of 6FAP was dissolved in 200 g of NMP, and a resulting solution was then cooled to -10 °C. Subsequently, 26.37 g (0.085 mol) of ODPA was slowly added, so that a temperature of reaction solution did not exceed 0 °C. Stirring was continued for 3 hours, and then 4.44 g (0.03 mol) of PhA was added. Stirring was continued at room temperature for 2 hours to yield a polyamic acid solution.

39.55 g of Py and 30.6 g of Et2A were added into the polyamic acid solution, and mixture was heated to 120 °C, and then further reacted for 12 h. Upon completion of reaction, solution was poured into 2 L of deionized water for precipitation. Precipitate was washed with water and vacuum-dried at 80 °C to yield a polyimide resin A4, with a structural formula as shown below:

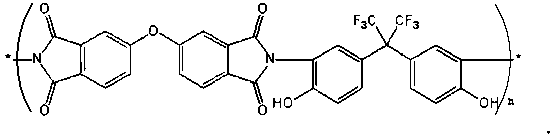

### Examples 1-15 and Comparative Examples 1-3

Photosensitive compositions of Examples 1-15 and Comparative Examples 1-3 were prepared based on components and formulations listed in Tables 1-3. Compounding amounts in Tables 1-3 were parts by mass of each component relative to 100 parts by mass of the component (a), respectively.

The components (b) to component (f) used in Tables 1-3 were selected as follows.

### Component (b): photoacid generator

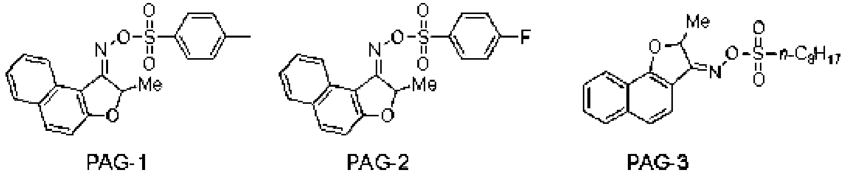

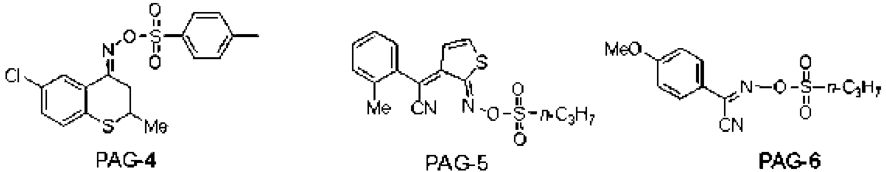

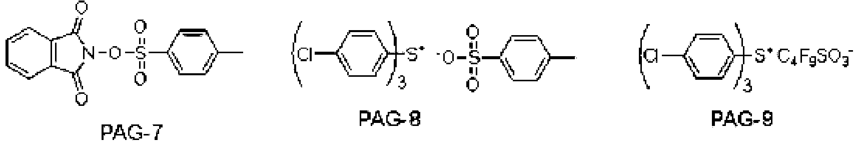

### Component (c): thermal crosslinker

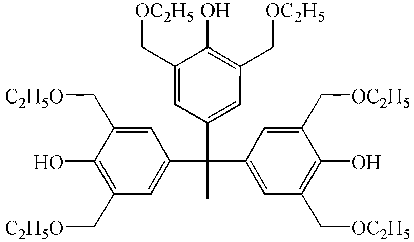

### Component (d): alkaline compound

DIA: 2,6-diisopropylaniline
PEA: N-phenyldiethanolamine
Component (e): γ-ureidopropyltriethoxysilane
Component (f): solvent
f1: GBL (γ-butyrolactone)
f2: EL (ethyl lactate)

**Table 1 Components of Photosensitive Composition**

| | | Example 1 | Example 2 | Example 3 | Example 4 | Example 5 | Example 6 |
|---|---|---|---|---|---|---|---|
| (a) | Polymer A1 | | | | | | |
| | Polymer A2 | 100 | 100 | 100 | 100 | 100 | 100 |
| | Polymer A3 | | | | | | |
| | Polymer A4 | | | | | | |
| (b) | PAG-1 | 2 | | | | | |
| | PAG-2 | | 2 | | | | |
| | PAG-3 | | | 2 | | | |
| | PAG-4 | | | | 2 | | |
| | PAG-5 | | | | | 2 | |
| | PAG-6 | | | | | | 2 |
| | PAG-7 | | | | | | |
| | PAG-8 | | | | | | |
| | PAG-9 | | | | | | |
| | b' | | | | | | |
| (c) | | 15 | 15 | 15 | 15 | 15 | 15 |
| (d) | DIA | 0.1 | | 0.1 | | 0.1 | 0.1 |
| | PEA | | 0.1 | | 0.1 | | |
| (e) | | 2 | 2 | 2 | 2 | 2 | 2 |
| (f) | f1 | 144 | 144 | 144 | 144 | 144 | 144 |
| | f2 | 36 | 36 | 36 | 36 | 36 | 36 |

**Table 2 Components of Photosensitive Composition**

| | | Example 7 | Example 8 | Example 9 | Example 10 | Example 11 | Example 12 |
|---|---|---|---|---|---|---|---|
| (a) | Polymer A1 | | | | | | |
| | Polymer A2 | 100 | 100 | 100 | 100 | 100 | 100 |
| | Polymer A3 | | | | | | |
| | Polymer A4 | | | | | | |
| (b) | PAG-1 | | | | | | |
| | PAG-2 | | | | | | |
| | PAG-3 | | | | | | |
| | PAG-4 | | | | | | |
| | PAG-5 | | | | 2 | 2.5 | 3 |
| | PAG-6 | | | | | | |
| | PAG-7 | 2 | | | | | |
| | PAG-8 | | 2 | | | | |
| | PAG-9 | | | 2 | | | |
| | b1 | | | | | | |
| (c) | c1 | 15 | 15 | 15 | 20 | 15 | 15 |
| (d) | DIA | 0.1 | 0.1 | | 0.1 | | 0.1 |
| | PEA | | | 0.1 | | 0.1 | |
| (e) | | 2 | 2 | 2 | 2 | 2 | 2 |
| (f) | f1 | 144 | 144 | 144 | 144 | 144 | 144 |
| | f2 | 36 | 36 | 36 | 36 | 36 | 36 |

**Table 3 Components of Photosensitive Composition**

| | | Example 13 | Example 14 | Example 15 | Comparative Example 1 | Comparative Example 2 | Comparative Example 3 |
|---|---|---|---|---|---|---|---|
| (a) | Polymer A1 | | | | 100 | | - |
| | Polymer A2 | 100 | 100 | 100 | | | |
| | Polymer A3 | | | | | 100 | |
| | Polymer A4 | | | | | | 100 |
| (b) | PAG-1 | | | | | | |
| | PAG-2 | | | | | | |
| | PAG-3 | | | | | | |
| | PAG-4 | | | | | | |
| | PAG-5 | 2 | 2 | 2 | 2 | | |
| | PAG-6 | | | | | | |
| | PAG-7 | | | | | | |
| | PAG-8 | | | | | | |
| | PAG-9 | | | | | | |
| | b1 | | | | | 15 | 15 |
| (c) | c1 | 20 | 10 | 30 | 15 | 15 | 15 |
| (d) | DIA | 0.1 | | | | | |
| | PEA | | 0.1 | 0.1 | 0.1 | | |
| (e) | | 2 | 2 | 2 | 2 | 2 | 2 |
| (f) | f1 | 144 | 144 | 144 | 144 | 144 | 144 |
| | f2 | 36 | 36 | 36 | 36 | 36 | 36 |

Performance of the photosensitive compositions prepared in Examples 1-15 and Comparative Examples 1-3 was evaluated by methods as follows.

### (1) Preparation of Developing Films

The photosensitive compositions (varnishes) prepared in Examples 1-15 and Comparative Examples 1-3 were each spin-coated on an 8-inch silicon wafer, and then subjected to heat treatment (prebaking) at 120 °C for 3 minutes using a hotplate (manufactured by Tokyo Electron Ltd., coating/developing apparatus Mark-7), to manufacture prebaked films with a thickness of 6 µm. The obtained prebaked films were exposed using an i-line stepper (manufactured by Nikon Corporation, NSR-2005i9C) with an exposure amount of 50-400 mJ/cm² and a step of 10 mJ/cm². After exposure, the photosensitive polyimide compositions were exposed at 100 °C for 1 minute before baking. After exposure and then baking, the photosensitive polyimide compositions were developed with a 2.38 wt% tetramethylammonium hydroxide (TMAH) aqueous solution (manufactured by Mitsubishi Gas Chemical Company, Inc., ELM-D) for 90 seconds, and then rinsed with pure water, to yield developed films.

### (2) Evaluation of Thickness Loss of Developed Films

Film thickness after the prebaking and development was measured using a film thickness measurement apparatus Filmtris F50 with a refractive index of 1.63. Film thickness loss less than 0.2 µm was rated A, film thickness between 0.2 µm and 1 µm was rated B, film thickness loss between 1 µm and 2 µm was rated C, and film thickness loss greater than 2 µm was rated D. Results are listed in Table 4.

### (3) Measurement of Warpage

The varnishes were spin-coated using a coating/developing apparatus ACT-8, and prebaked at 120 °C for 3 minutes, to produce a prebaked thickness of 10 µm. After that, the wafers were heated to 200 °C using an inert oven at an oxygen concentration of 20 ppm or less at a rate of 3.5 °C/min, and subjected to a heating treatment at 200 °C for 1 hour. When the temperature became 50 °C or less, the wafers were taken out, and the cured films were measured using a pressure apparatus FLX2908 (manufactured by KLA Tencor). For results, 35 MPa or higher was rated insufficient (D), 30 MPa or higher and lower than 35MPa was rated good (C), 20 MPa or higher and lower than 30 MPa was rated better (B), and lower than 20 MPa was rated best (A). The results are listed in Table 4.

### (4) Evaluation of Sensitivity

After exposure and development, an exposure dose for forming a 1:1 line-and-space pattern (1 L / 1 S) with a 20 µm width (called as optimal exposure dose Eop) is defined as sensitivity. Eth of 200 mJ/cm² or lower can be determined to indicate high sensitivity. 150 mJ/cm² or lower is more preferable. Results are listed in Table 4.

### (5) Evaluation of Chemical Resistance

The photosensitive compositions were each coated on the above cured products by a pipette. The coated cured products were placed in a nitrogen oven and held at 200 °C for 60 minutes. Then, the cured products were transferred from the hotplate and cooled to room temperature. The cooled cured products were cleaned with NMP at 45 °C and soaked for 1 h to measure the film thicknesses.

A film thickness change rate (%) was calculated from changes in the film thickness. A positive value indicates film expansion, and a negative value indicates film dissolution. Results are listed in Table 4.

### (6) Evaluation of Adhesion

The cured products were manufactured on the Cu substrate using the above preparation method for the cured product. Each obtained cured product was cut to make incisions in a 10 × 10 grid pattern with a shear knife using a crosscut guide (manufactured by COAT-TECH Co., Ltd.), thereby dividing the cured product into 100 small squares.

An adhesive tape (manufactured by 3M Japan Limited) was attached to the above cured product, and the adhesive tape was peeled off. The adhesion was evaluated in accordance with the number of the cured product squares peeled from the substrate when the adhesive tape was peeled off.
A: The number of residual squares was 100-80.
B: The number of residual squares was less than 80.

### Results are listed in Table 4.

### (7) Evaluation of Elongation at Break

The varnishes were spin-coated using the coating/developing apparatus ACT-8, and prebaked at 120 °C for 3 minutes, to produce a prebaked thickness of 10 µm. After that, the wafers were heated to 200 °C using an inert oven at an oxygen concentration of 20 ppm or lower at a rate of 3.5 °C/min, and subjected to a heating treatment at 200 °C for 1 hour. When the temperature became 50 °C or lower, the wafers were taken out, the films were peeled off and cut into 4 mm × 8 mm strips, to undergo a DAGE4000 tensile test.

For results, the elongation at break of 30% or higher was rated excellent (A), 20-30% was rated good (B), 10-20% was rated poor (C), and <10% was rated extremely poor (D). The results are listed in Table 4.

**Table 4 Detection Results**

| | Elongation at Break | Warpage Stress | Sensitivity | Film Thickness Loss | Chemical Resistance | Adhesion |
|---|---|---|---|---|---|---|
| Example 1 | A | A | 120 mJ/cm² | A | no change | A |
| Example 2 | A | A | 130 mJ/cm² | A | no change | A |
| Example 3 | A | A | 125 mJ/cm² | A | no change | A |
| Example 4 | A | A | 120 mJ/cm² | A | no change | A |
| Example 5 | A | A | 115 mJ/cm² | A | no change | A |
| Example 6 | A | A | 125 mJ/cm² | A | no change | A |
| Example 7 | A | A | 120 mJ/cm² | A | no change | A |
| Example 8 | A | A | 110 mJ/cm² | A | no change | A |
| Example 9 | A | A | 113 mJ/cm² | A | no change | A |
| Example 10 | A | A | 110 mJ/cm² | A | no change | A |
| Example 11 | A | A | 105 mJ/cm² | A | no change | A |
| Example 12 | A | A | 100 mJ/cm² | A | no change | A |
| Example 13 | A | A | 115 mJ/cm² | A | no change | A |
| Example 14 | A | A | 120 mJ/cm² | A | no change | A |
| Example 15 | B | B | 123 mJ/cm² | A | no change | A |
| Comparative Example 1 | A | A | no contrast | D | no change | A |
| Comparative Example 2 | D | B | 300 mJ/cm² | C | swelling 5% | A |
| Comparative Example 3 | A | C | 400 mJ/cm² | B | film reduction 20% | A |

As can be seen from Table 4, the photosensitive compositions provided by Examples 1-15 of the present invention have high sensitivity, excellent low warpage stress, and excellent chemical resistance. Compared with the examples, Comparative Example 1 exhibited no contrast and relatively large loss of the developed film thickness, Comparative Example 2 had relatively poor toughness and poor sensitivity, and Comparative Example 3 had high warpage stress, relatively poor sensitivity, and relatively poor chemical stability.

The above-mentioned are only for preferred embodiments of the present invention and are not intended to limit the present invention. For those skilled in the art, the present invention could have various modifications and changes. Any modifications, equivalent substitutions, improvements and the like made within the spirit and principle of the present invention should be covered within the scope of protection of the present invention.

### INDUSTRIAL APPLICABILITY

The part of the photosensitive composition provided by the present invention exposed to ultraviolet light is readily soluble in the alkaline aqueous solution, while the part not exposed to the ultraviolet light is insoluble in the alkaline aqueous solution, so that fine patterns can be effectively replicated. The photosensitive composition exhibits excellent sensitivity and high resolution, and after low-temperature curing (180-200 °C), it has low warpage stress, high adhesion, and good chemical resistance, thus being suitable for industrial production.

## Claims

1. A photosensitive composition, **characterized by** comprising a component (a) graft polymer selected from compounds represented by Formula 1 as follows: 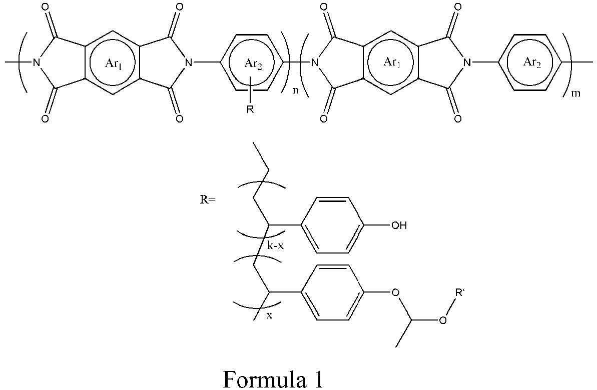
wherein Ar₁ is selected from tetravalent organic groups, Ar₂ is selected from divalent organic groups, and R' is any one selected from the group consisting of alkyl, alkoxy, cycloalkyl, and aryl; m + n = 5 to 200, n / (m + n) = 0.05 to 1, k = 2 to 10, and x = 0.5 to10;
a component (b) photoacid generator;
a component (c) thermal crosslinker, which is a CH₂OR"-containing crosslinker, R" being hydrogen or a monovalent organic group; and
a component (d) alkaline compound.

2. The photosensitive composition according to claim 1, wherein Ar₁ is, at each occurrence, identically or differently any one selected from tetravalent organic groups represented by Formula 2-1 to Formula 2-9 as follows: 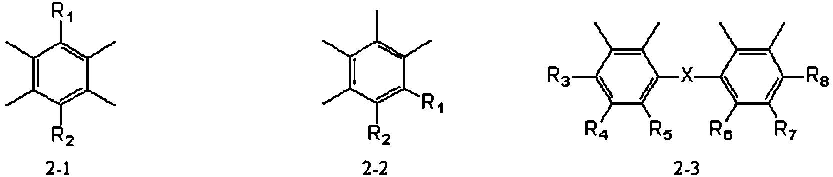 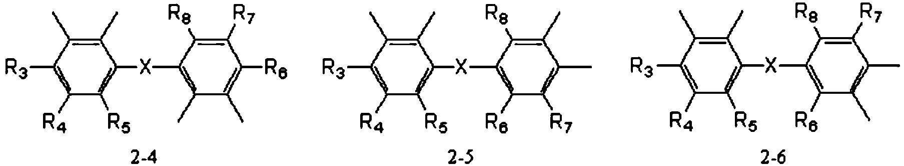 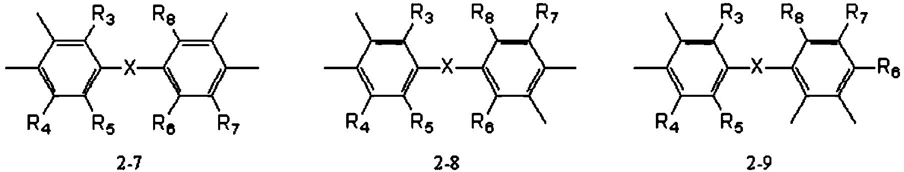 wherein R₁ to R₈ are each a monovalent organic group, and X is a divalent group.

3. The photosensitive composition according to claim 1 or 2, wherein R₁ to R₈ are each independently any one selected from the group consisting of hydrogen, halogen, and C₁-C₅ substituted or unsubstituted alkyl.

4. The photosensitive composition according to claim 2 or 3, wherein R₁ to R₈ are each independently any one selected from the group consisting of hydrogen, fluorine atom, methyl, and trifluoromethyl.

5. The photosensitive composition according to any one of claims 2-4, wherein X is any one selected from the group consisting of oxygen atom, C₁-C₅ substituted or unsubstituted alkylene, sulfur atom, sulfone, and carbonyl.

6. The photosensitive composition according to any one of claims 2-5, wherein X is any one selected from the group consisting of oxygen atom, methylene, sulfur atom, sulfone, carbonyl, C(CH₃)₂, and C(CF₃)₂.

7. The photosensitive composition according to any one of claims 1-6, wherein Ar₂ is, at each occurrence, identically or differently any one selected from divalent organic groups represented by Formula 3-1 to Formula 3-12 as follows: 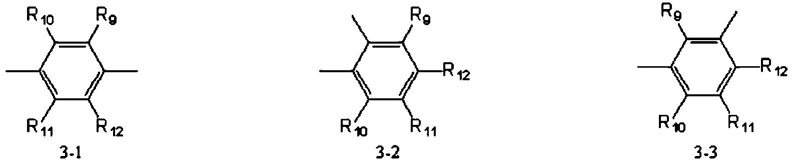 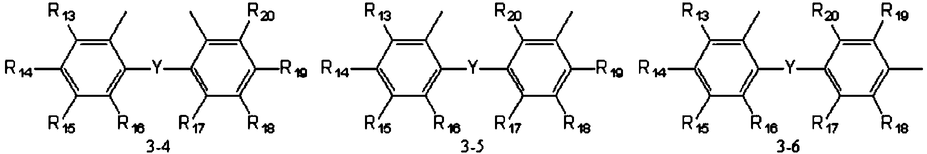 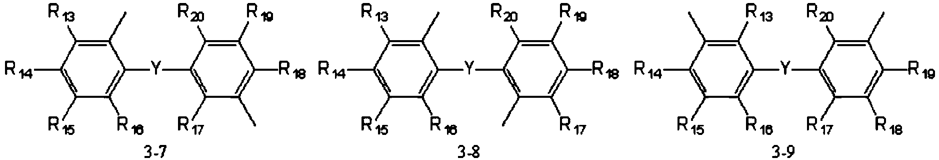 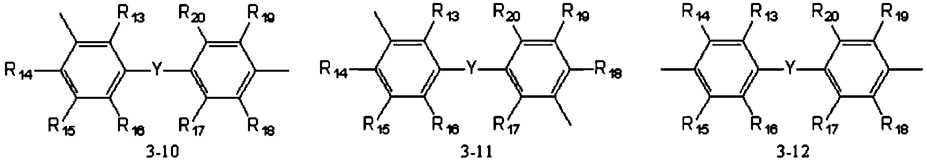 wherein R₉ to R₂₀ are each a monovalent organic group, and Y is a divalent group.

8. The photosensitive composition according to claim 7, wherein R₉ to R₂₀ are each independently any one selected from the group consisting of hydrogen, halogen, and C₁-C₅ substituted or unsubstituted alkyl.

9. The photosensitive composition according to claim 7 or 8, wherein R₉ to R₂₀ are each independently any one selected from the group consisting of hydrogen, fluorine atom, methyl, and trifluoromethyl.

10. The photosensitive composition according to any one of claims 7-9, wherein Y is any one selected from the group consisting of oxygen atom, C₁-C₅ substituted or unsubstituted alkylene, sulfur atom, sulfone, and carbonyl.

11. The photosensitive composition according to any one of claims 7-10, wherein Y is any one selected from the group consisting of oxygen atom, methylene, sulfur atom, sulfone, carbonyl, C(CH₃)₂, and C(CF₃)₂.

12. The photosensitive composition according to any one of claims 1-11, wherein the component (b) is a compound that generates an acid upon irradiation at 365 nm.

13. The photosensitive composition according to claim 12, wherein the component (b) is a triarylsulfonium salt.

14. The photosensitive composition according to claim 12 or 13, wherein sulfonate anions contained in the triarylsulfonium salt are fluorine-containing sulfate anions.

15. The photosensitive composition according to any one of claims 1-14, wherein the component (c) is selected from compounds represented by Formula 4-2-1 and/or Formula 4-2-2 as follows: 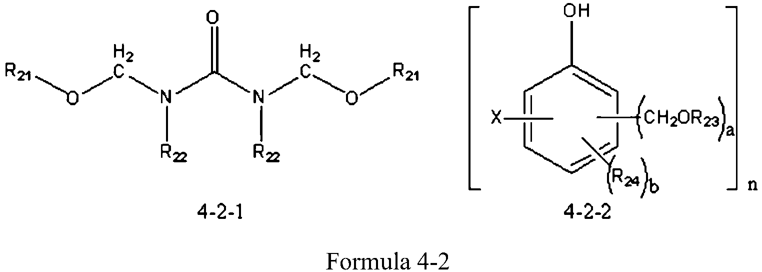
in Formula 4-2-1, R₂₁ is independently a hydrogen atom or a monovalent organic group, and R₂₂ is independently a hydrogen atom or a monovalent organic group, or R₂₁ and R₂₂ can be combined with each other to form a ring structure having a substituent; and
in Formula 4-2-2, R₂₃ is a hydrogen atom or a monovalent organic group, R₂₄ is a monovalent organic group, n is an integer from 1 to 4, X is a single bond or a monovalent to tetravalent organic group; a is an integer from 1 to 4, b is an integer from 0 to 3, R₂₃ is identical or different when a is 2, 3 or 4, and R₂₄ is identical or different when b is 2 or 3.

16. The photosensitive composition according to any one of claims 1-15, wherein the component (c) is any one selected from compounds represented by structural formulas as follows: 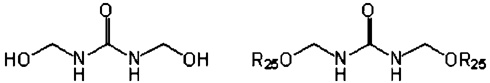 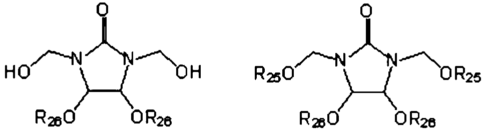 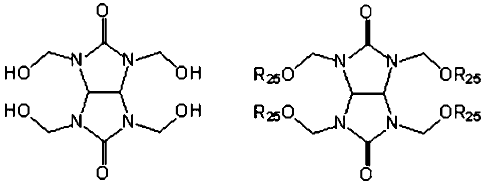 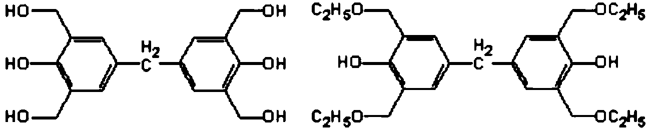 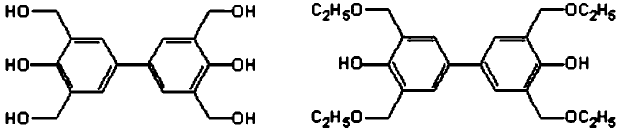 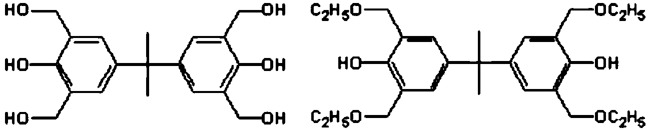 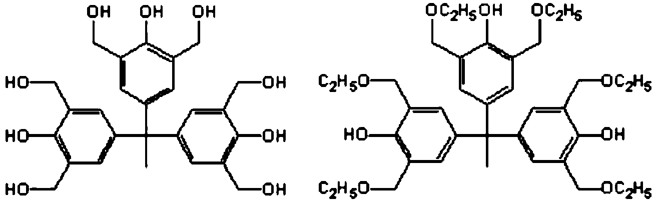 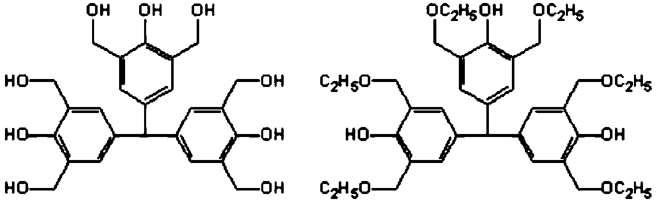 wherein R₂₅ is an alkyl group having 1 to 20 carbon atoms, and R₂₆ is an alkyl group having 1 to 10 carbon atoms.

17. The photosensitive composition according to claim 16, wherein R₂₅ is an alkyl group having 1 to 6 carbon atoms.

18. The photosensitive composition according to any one of claims 1-17, wherein the component (d) is a compound represented by a structural formula as follows: 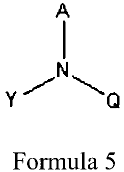 wherein A, Y, and Q are each independently selected from the group consisting of alkyl, alkoxy, and cyclic alkyl.

19. The photosensitive composition according to any one of claims 1-18, wherein the component (d) is any one selected from compounds represented by structural formulas as follows:

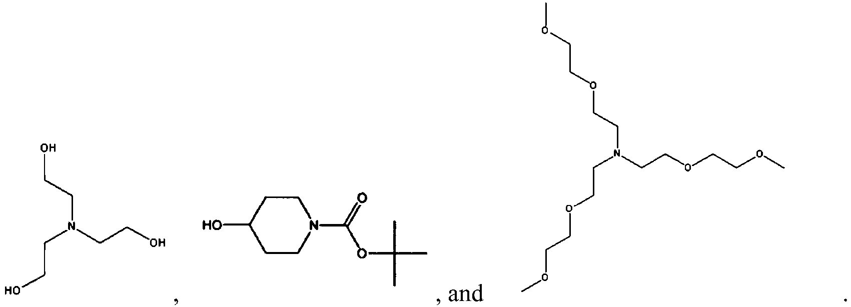

20. The photosensitive composition according to any one of claims 1-19, wherein based on 100 parts by weight of a content of the component (a), a content of the component (b) is 1-5 parts by weight, a content of the component (c) is 5 parts by weight or more, and a content of the component (d) is 0.001-2 parts by weight.

21. The photosensitive composition according to claim 20, wherein
the component (c) is 10 parts or more.

22. The photosensitive composition according to claim 20 or 21, wherein the component (c) is 5-30 parts by weight.

23. The photosensitive composition according to any one of claims 20-22, wherein a molar ratio of the component (b) to the component (d) is 2.5-300.

24. The photosensitive composition according to any one of claims 20-23, wherein a molar ratio of the component (b) to the component (d) is 7.0-150.

25. The photosensitive composition according to any one of claims 1-24, wherein the photosensitive composition further contains any one or combination of at least two selected from the group consisting of a silane coupling agent, a solvent, and a leveling agent.

26. The photosensitive composition according to claim 25, wherein based on 100 parts by weight of a content of the component (a), a content of the silane coupling agent is 0.5-15 parts by weight, a content of the solvent is 50-1,000 parts by weight, and a content of the leveling agent is 100-1,000 ppm.

27. A preparation method for a pattern, **characterized by** comprising: coating the photosensitive composition according to any one of claims 1-26 on a supporting substrate.

28. The preparation method according to claim 27, further comprising: performing drying, exposure, development, and heating treatment in sequence after the coating.

29. The preparation method according to claim 28, wherein a light source used in a step of the exposure is i-line.

30. A cured product, **characterized in that** the cured product is formed by curing the photosensitive composition according to any one of claims 1-26.

31. The cured product according to claim 30, wherein the cured product comprises a surface protective film or an interlayer insulating film.

32. An electronic component, **characterized in that** the electronic component has the cured product according to claim 30 or 31.
